(19) Europäisches Patentamt / European Patent Office / Office européen des brevets

(11) **EP 3 138 675 A1**

(12) **EUROPEAN PATENT APPLICATION**

(43) Date of publication:
08.03.2017 Bulletin 2017/10

(21) Application number: 15183867.9

(22) Date of filing: 04.09.2015

(51) Int Cl.:
*B27K 3/00* (2006.01)     *B05D 3/10* (2006.01)
*B05D 7/06* (2006.01)     *B27K 3/20* (2006.01)
*B27K 3/22* (2006.01)     *B27K 3/32* (2006.01)
*B32B 15/10* (2006.01)     *B82Y 30/00* (2011.01)
*C01G 9/02* (2006.01)     *C09D 5/32* (2006.01)
*C09D 7/12* (2006.01)     *C30B 29/16* (2006.01)
*B27K 3/34* (2006.01)     *B27K 3/52* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **ETH Zurich**
**8092 Zurich (CH)**

(72) Inventors:
• **BURGERT, Ingo**
  **8607 Seegräben (CH)**
• **CABANE, Etienne**
  **8004 Zürich (CH)**
• **GUO, Huizhang**
  **8046 Zürich (CH)**

(54) **UV-STABLE AND SUPERHYDROPHOBIC WOOD SURFACE**

(57) The invention relates to a method for treatment of wood material. In a first treatment step comprises the provision of a solution comprising zinc oxide or titanium(IV) isopropoxide and immersion of the wood material into the solution. After drying of the wood material a second treatment step is following in case of the first solution comprising zinc oxide. The second treatment step comprises the provision of a solution comprising a zinc compound and immersion of the wood material from the first treatment step into the solution followed by drying of the wood material. In a second aspect the invention relates to a wood material characterized by the visibility of the natural appearance of the surface and at least one other property relating to UV resistance, weathering resistance, mechanical resistance or hydrophobic properties.

Fig. 2

**Description**

Field of the invention

The present invention relates to a method for the treatment of wood material for protection against UV exposure and weathering as well as a wood material with resistance to UV exposure and weathering.

Background of the invention

Wood is an excellent and widely used sustainable material for various applications such as construction and furniture, but it is prone to degradation under UV exposure. UV degradation leads to colour changes, surface alterations, and even to the destruction of wood material in presence of water, which strongly affects the reliability of wood in various applications.

Among the chemical components comprised in wood material, the highly branched phenolic polymer lignin is the best UV absorber in comparison to hemicellulose and cellulose. As a result, UV light in the solar spectrum can induce lignin degradation via photo-oxidation. The natural polymers undergo bond cleavage and hydrogen abstraction resulting in the formation of radicals or peroxides which finally decompose and generate the coloured and hydrophilic by-products (chromophores). Lignin is fragmented into low molecular weight species (such as water soluble polyphenols), which are washed away with the flow of water in outdoor applications. This exposes the underlying structure and leads to a degraded surface, which is more prone to fungal attack. In consequence, the photochemical reactions induced by UV radiation result in a significant surface alteration of wood such as loss of gloss and surface roughening, affecting its aesthetic appeal. Hence, there has been a widespread interest in preventing the photo-degradation of wood.

In the prior art different techniques to protect wood materials are known, which include chemical modification of the wood polymers, surface treatment with additives (organic and inorganic UV absorbers, radical scavengers), and finishing (varnishes and opaque coatings). Chemical modification of wood was typically carried out by bonding chemicals to the cell wall polymers that stabilize the colour of wood, such as acetylation and silylation. However, acetylated wood exhibited a colour stabilization effect only for 28 days, thereafter, the stabilization effect steadily diminishes and discoloration starts (Hon et al., Wood Fiber Sci. 27, 360-367; 1995). Silylation, thermal and copper ethanolamine treatment also caused the colour changing of wood specimens inevitably (Deka, M. et al. Wood Sci. Technol. 42, 5-20, 2008). Moreover, the photo degradation and leaching out of the organic molecules from the modified wood can be harmful to the environment and make the application of wood materials unsustainable. Wood surface coatings with inorganic nanoparticles as UV absorbers have the main drawback of leaching of added particles over time, lowering the protection efficiency, and necessitating regular application of new layers. In an attempt to overcome this limitation, a mix of inorganic UV absorbers and a clear organic coating to obtain highly durable and efficient UV protection coating was tested. ZnO-based acrylate coatings were applied to reduce yellowing under UV exposure. However, the self-degradation of the applied polymers limits their long-term performance in photo-stabilizing wood. In-situ coating of the substrate with a semiconductor layer via a liquid route, which has been developed by chemists for solar cell or transparent conductive electrodes, is emerging as a facile and promising method for wood UV protection. However, a ZnO nanorod array with a strong scattering effect to visible light diminishes the aesthetic appearance of wood surfaces. More importantly, the low crystalline coating exhibits poor durability under weathering conditions.

Here the inventors disclose a ZnO or titania based treatment method for protection of wood against UV as well as to achieve water repellent wood surfaces. The novelty of this invention is an in-situ treatment method to treat the rough wood surface (uneven topography with cut-open cells) with titania or ZnO nanorod arrays or a continuous film in the assistance of capping agents without exceeding temperature of 120°C in case of ZnO or 200°C in case of titania at any step. By further modifying the surface layer with hydrophobic molecules, a super-hydrophobic wood surface with low water drop adhesion can be achieved.

The problem underlying the present invention is to provide the means for a durable treatment of wood materials to increase their photostability and weathering resistance using an environmentally friendly, easy to use, and economic method. This problem is solved by the subject-matter of the independent claims.

Summary of the invention

The finding was made that titania or ZnO nanorod arrays or continuous films deposited onto the surface and/or within the first cell layer of wood material yield a UV-stable wood surface. The natural appearance of the surface of the wood material is preserved after treatment.

Furthermore, the UV-stable wood material can be further protected against the influence of environmental factors by deposition of thin $SiO_2$ blocking layers onto the surface of ZnO nanorod arrays or continuous films in a conformational manner. This treatment also stabilizes hydrophobic molecules that may be introduced to the surface against a photo catalytic effect of ZnO in the presence of UV light.

Additionally, the ZnO treated wood material with or without the $SiO_2$ treatment might be treated with hydrophobic molecules to yield a UV-stable and super-hydrophobic wood surface with low water drop adhesion.

The disclosed invention is a treatment of wood materials comprised of titania or ZnO nanorod arrays or a continuous film and hydrophobic molecules obtained by an in-situ coating method. This UV-stable and super-hydrophobic wood treatment with low water drop adhesion is obtained without exceeding temperatures of 120°C in case of ZnO or 200°C in case of titania at any step of the process. The presented method can be easily scaled-up for large scale surface modification.

According to a first aspect of the invention a method for treatment of wood material comprising a first and in some cases a second treatment step is provided. The first treatment step comprises the steps of provision of a first solution, immersion of the wood material into the first solution and drying of the wood material. In case of a second treatment step this step comprises the steps of provision of a second solution, immersion of the wood material into the second solution and drying of the wood material.

According to a second aspect of the invention a wood material is provided that is characterized by its resistance to UV exposure and weathering.

According to a third aspect of the invention a wood material obtainable by a process according to the first aspect of the invention is provided

Detailed description of the invention

The first aspect of the invention relates to a method for treatment of wood material that comprises a first and in some cases a second treatment step. In the first treatment step a first solution comprising zinc oxide in an aqueous solution or titanium(IV) isopropoxide (TTIP; CAS No: 546-68-9) in an organic solvent, in particular an alcohol, more particular ethanol, is provided. The wood material is immersed in the first solution and afterwards transferred to an oven suitable for drying of the wood material.

In case that the first solution comprises zinc oxide the method additionally comprises a second treatment step. In the second treatment step a second solution comprising a zinc compound is provided and the wood material obtained by the first treatment step is immersed in the second solution and dried afterwards.

In the context of the present specification the term *coating* relates to depositions on the surface of materials as well as depositions on the surface that additionally penetrate into the upper layers of the material.

In certain embodiments, the first solution comprising zinc oxide has a pH > 7, in particular a pH 8-14, more particular a pH 9-13, most particular pH 10 to 12.

In certain embodiments, the first solution has a pH of around 11, particular pH 11.

In certain embodiments, the second solution has a pH $\geq$ 7, in particular a pH 7-14, more particular a pH 8-13, most particular pH 10 to 12.

In certain embodiments, the second solution has a pH of around 11,4, particular 11,4.

In certain embodiments, the first solution comprising zinc oxide has a pH > 7, in particular a pH 8-14, more particular a pH 9-13, most particular pH 10 to 12 and the second solution has a pH $\geq$ 7, in particular a pH 7-14, more particular a pH 8-13, most particular pH 10 to 12.

In certain embodiments, the first solution has a pH of around 11, particular pH 11 and the second solution has a pH of around 11,4, particular 11,4.

In certain embodiments, the first solution comprises zinc oxide with a concentration of 30 to 60 mM ZnO, particularly 40 to 55 mM ZnO, more particularly 40 to 50 mM ZnO and most particularly 50 mM ZnO.

In certain embodiments, the first solution comprising titanium(IV) isopropoxide (TTIP) with a concentration from 1 wt% to 10 wt%, in particular 2 wt% to 8 wt%, more particular 4 wt% to 6 wt%.

In the context of the present specification the term *percentage by weight (wt%)* refers to the ratio of the mass of one substance to the mass of the total mixture multiplied by 100. Percentage by weight is calculated according to formula:

$$wt\% = \left(\frac{m_s}{m_{tot}}\right) \times 100$$

with $m_s$ being the mass of one substance in a mixture and $m_{tot}$ the mass of the total mixture.

In certain embodiments, in the first treatment step the wood material is immersed into the first solution comprising zinc oxide for 30 seconds up to 5 minutes, particularly 3 minutes to 5 minutes, more particularly 5 minutes.

In certain embodiments, in the first treatment step the wood material is immersed into the first solution comprising TTIP for 12 hours up to 36 hours, in particular 14 hours to 24 hours, more particular 24 hours.

In certain embodiments, the wood material is immersed in the second treatment step into the second solution for at least 5 minutes, in particular 5 minutes to 240 minutes, more particular 30 minutes to 150 minutes, most particular 120 minutes.

In certain embodiments, the second solution has a temperature of 70°C to 110°C, in particular 70°C to 90°C, more particular 85°C.

In certain embodiments in the first treatment step in case of the first solution comprising zinc oxide the drying of the wood material is performed at a temperature of 80°C to 110°C, particularly 90°C to 110°C more particularly 110°C.

In certain embodiments in the first treatment step in case the first solution comprising zinc oxide the drying of the wood material is performed for at least 2 minutes, particularly 2 to 30 minutes, more particularly 10 minutes.

In certain embodiments in the first treatment step in case of the first solution comprising TTIP drying of the wood material is performed in three steps:

- at a temperature of 50°C to 80°C, in particular 65°C, in the first step, and
- at a temperature of 50°C to 150°C, in particular 120°C, in the second step, and
- at a temperature of 50°C to 200°C, in particular 180°C, in the third step;

wherein the drying time is:

- at least 1 hour, in particular between 1 hour and 3 hours, more particular 2 hours in the first step, and
- at least 30 minutes and 2 hours, in particular 1 hour, in the second step, and
- between 15 minutes and 1 hour, in particular 30 minutes in the third step.

In certain embodiments in the second treatment step drying of the wood material is performed at a temperature of 50°C to 80°C, in particular 60°C to 80°C, more particular 65°C for at least 2 hours, in particular 2h to 16h, more particular 4h to 12h.

In certain embodiments, the zinc compound of the second solution is selected from zinc oxide, zinc nitrate and zinc acetate.

In certain embodiments, the second solution comprises zinc oxide or zinc nitrate with a concentration higher than that of a saturated zinc oxide or zinc nitrate solution, in particular a zinc oxide solution with a concentration higher than that of a saturated zinc oxide solution.

In the context of the present specification the term *saturated solution* refers to a solution of a substance that cannot dissolve more of that substance under standard conditions. Addition of more substance yields a separate phases (solid). The concentration of a saturated solution depends on parameters such as temperature, pressure, solvent, pH and other compounds present in the solution. Changes to these parameters that further increase the solubility of the substance results in solutions that with a concentration that is higher than that of a saturated solution.

In certain embodiments, the second solution comprises zinc oxide with a concentration of 40 to 65 mM, particularly 40 to 55 mM, more particularly 50 mM.

In certain embodiments, the second solution comprises zinc nitrate with a concentration of 40 to 65mM, particularly 40 to 55 mM more particularly 50 mM.

In certain embodiments, the second solution comprises zinc acetate with a concentration of 40 to 110 mM, particularly 50 to 100 mM.

In certain embodiments, the second solution comprises zinc oxide and ammonium hydroxyl.

In certain embodiments, the second solution comprises zinc oxide and at least one ammonium salt.

In certain embodiments, the second solution comprises zinc oxide and ammonium hydroxyl and at least one ammonium salt.

In certain embodiments, the second solution comprises zinc nitrate and hexamethylentetramine (HMTA; CAS 100-97-0).

In certain embodiments, the second solution comprises zinc nitrate, hexamethylentetramine and at least one ammonium salt.

In certain embodiments, the second solution comprises zinc acetate and hexamethylentetramine.

In certain embodiments, the second solution comprises zinc acetate, hexamethylentetramine and at least one ammonium salt.

In certain embodiments the ammonium salt is selected from ammonium citrate [$(NH_4)_3(C_6H_5O_7)$], ammonium nitrate [$NH_4NO_3$], ammonium acetate [$CH_3COONH_4$] and ammonium chloride [$NH_4Cl$].

Ammonium salt or HMTA is used to increase the solubility of zinc compounds, in particular zinc oxide, zinc nitrate or zinc acetate.

In certain embodiments, the second solution is an aqueous solution.

In certain embodiments the wood material in the second treatment step is immersed into the second solution for at least 5 minutes, particularly 5 minutes to 240 minutes, more particularly 30 minutes to 150 minutes, most particularly 120 minutes.

In certain embodiments the second solution in the second treatment step has a temperature of 70°C to 110°C, particularly 70°C to 90°C, more particularly 85°C.

In certain embodiments, the wood material in the second treatment step is dried at a temperature of 50°C to 80°C, particularly 60°C to 80°C, more particularly 65°C.

In certain embodiments, the wood material in the second treatment step is dried for at least 2 hours, particularly 2h to 16h, more particularly 4h to 12h.

In certain embodiments, the time and temperature of drying in the second treatment step may be increased depending on the size of the wood material.

A non-limiting example is wood material of the dimensions radial (R) x tangential (T) x longitudinal (L) dimensions: 5x25x40 mm requiring a drying of at least 5 minutes at 60°C, preferably 60°C for 2 hours. Wood material of smaller or larger dimension might require proportionally shorter or longer, respectively and/or lower temperatures. In general requires wood material of larger dimensions longer drying time than wood material of smaller dimensions.

In certain embodiments, the first and/or second treatment step is repeated at least once.

In certain embodiments, the method according to the first aspect of the invention in case of the first solution comprising zinc oxide further comprises a stabilization step. The stabilization step is further comprising in this sequential order the steps of:

- provision of a stabilizing solution comprising a precursor of $SiO_2$,
- immersion of the wood material obtained after completion of the first and second treatment step into the stabilizing solution.

In certain embodiments, the stabilizing solution comprises a precursor of $SiO_2$, water and organic solvent and ammonium hydroxide.

In certain embodiments, the stabilizing solution comprises as a precursor of $SiO_2$ tetraethyl orthosilicate.

In certain embodiments, the stabilizing solution comprises ammonium hydroxide, tetraethyl orthosilicate as a precursor of $SiO_2$, and water and organic solvent, particularly water and alcohol, more particularly water and ethanol.

In certain embodiments, the stabilizing solution comprises water and organic solvent, particularly water and alcohol, more particularly water and ethanol.

In certain embodiments, the stabilizing solution comprises ammonium hydroxide.

In certain embodiments, the wood material is immersed into the stabilizing solution for 1h to 6h, particularly 2h to 5h and more particularly 3h to 4h.

In certain embodiments, in the stabilization solution the volume ratios of water to organic solvent, in particular alcohol, more particularly ethanol, ranges from 20:100 to 20:70.

In certain embodiments, in the stabilization solution the volume ratios of water to ammonium hydroxide range from 20:0.5 to 20:1.5.

In certain embodiments, in the stabilization solution the volume ratios of water to tetraethyl orthosilicate range from 20000:10 to 20000:60.

In certain embodiments, in the stabilization solution the volume ratios of:

- water to organic solvent, in particular alcohol, more particularly ethanol, ranges from 20:100 to 20:70; and
- water to ammonium hydroxide range from 20:0.5 to 20:1.5, and
- water to tetraethyl orthosilicate range from 20000:10 to 20000:60.

In certain embodiments, the method according to the first aspect of the invention further comprises a hydrophobization step comprising in this sequential order, the steps of:

i. provision of a hydrophobic solution comprising a hydrophobic molecule, in particular a long alkyl chain thiols, organic silanes, fatty acids, aromatic azide or fluorinated organic silane molecules,
ii. immersion of the wood material obtained after completion of the first and second treatment step or the wood material obtained after completion of the stabilization step into the hydrophobic solution and
iii. heat treatment of the wood material.

In certain embodiments, the method comprises, in case of the first solution comprising ZnO, the first treatment step, the second treatment step, the stabilization step and a hydrophobization step.

In certain embodiments, the method comprises the first treatment step, the second treatment step and a hydrophobization step.

In certain embodiments, the method comprises, in case of the first solution comprising ZnO, the first treatment step, the second treatment step and the stabilization step.

In certain embodiments, the hydrophobic solution comprises an organic solvent particularly alkanes or alcohols, more particularly hexane, ethanol or methanol.

In certain embodiments, the hydrophobic solution comprises a hydrophobic molecule selected from:

- 1H,1H,2H,2H-Perfluorooctyltriethoxysilane (CAS: 51851-37-7);
- Trichloro(1 H, 1H,2H,2H-perfluorooctyl)silane (CAS: 78560-45-9),
- decyltrichlorosilane ($CH_3(CH_2)_9SiCl_3$; CAS: 13829-21-5),
- 3,3,4,4,5,5,6,6,7,7,8,8,8-tridecafluorooctyl acrylate; CAS: 17527-29-6),
- stearic acid (CAS: 57-11-4)
- methyltrichlorosilane (CAS: 75-79-6),
- 1-Dodecanethiol (CAS: 112-55-0),
- Trimethoxy(octyl)silane (CAS: 3069-40-7).

In certain embodiments in the hydrophobization step the immersion time has a duration of 0.5 hours to 12 hours, particularly 2h to 12 hours, more particularly 4h to 12h, most particularly 12h.

In certain embodiments in the hydrophobization step the heat treatment is performed at a temperature of 50°C to 80°C, particularly 60°C to 70°C, more particularly 65°C, for a duration of 0.5 hours to 3 hours, particularly 3 hours.

According to a second aspect of the invention a wood material is provided. The wood material is characterized by the visibility of the natural appearance of the surface of the wood material and at least one of the following properties.

I. the resistance to UV induced changes in perceivable colour, wherein the said wood material has no decrease in lightness (L*) after at least 100 hours of UV exposure, and/or;

II. the resistance to UV induced changes in perceivable colour, wherein the said wood material has a change of red/green opponent colours (a*) of less than 2, in particular less than 1, after at least 100 hours of UV exposure, and/or

III. the resistance to UV induced changes in perceivable colour, wherein the said wood material has a change of yellow/blue opponent colours (b*) of less than 5, in particular less than 3, after at least 100 hours of UV exposure, and/or

IV. the wood material has a resistance to UV induced changes in perceivable colour, wherein the wood material has a total colour change ($\Delta E$) of less than 4, particularly less than 3, after at least 100 hours of UV exposure, and/or

V. the wood material also has resistance to weathering induced changes in perceivable colour, wherein the said wood material has a total colour change ($\Delta E$) of less than 4, particularly less than 3, after at least 100 hours of accelerated weathering as defined in table 1, and/or

VI. the wood material is characterized by the absence of X-ray diffraction peaks at degrees two-theta having a margin of error +/- 0.2 degrees 2-theta: 16.4° and 22.4°, and/or

VII. the counts for the X-ray diffraction peak at degrees two-theta 22.4° having a margin of error +/- 0.2 degrees 2-theta is below 20000, in particular below 15000, more particular below 13000.

VIII. the wood material is characterized by the presence of X-ray diffraction peaks at degrees two-theta having a margin of error +/- 0.2 degrees 2-theta: 31.77°, 34.42°, 36.25°, 47.54°, 62.86°, and/or

IX. the wood material has resistance to UV induced degradation of lignin, wherein the band characteristic for lignin in the FT-IR spectrum at 1507.3 cm$^{-1}$ is not significantly changed after 100 h of UV exposure as compared to wood material without UV exposure, and/or

X. the wood material has after at least 100 hours of UV exposure no significant increase in the band representing non-conjugated aliphatic carbonyls in the FT-IR spectrum at 1723.1 cm$^{-1}$ as compared to wood material without UV exposure, and/or

XI. superhydrophobic properties, wherein the advancing contact angle of a water drop is between 150° and 165°, in particular between 155° and 160°, most particular 160° and the receding contact angle of a water drop is between 145° and 165°, in particular between 150° and 160°, more particular between 155° and 160°, most particular 156°, the rolling of angle of water drop is 1.6°, and/or

XII. wood material comprising a coating, wherein the coating is resistant to mechanical damage and retains at least one of the properties I. to X after a blade scratch test or a tape-and-peel test.

Wood material has a characteristic surface comprising the grain and texture of the wood material. These surface properties are the reason for the aesthetic appearance of wood surfaces and are therefore advantageous properties of wood materials.

In some embodiments the contact angle of a water drop on the surface of the wood material is measured. The term contact angle refers to the angle formed by the intersection of the liquid-solid interface and the liquid-vapor interface.

In case the liquid used is water a contact angle smaller than 90° indicates a hydrophilic surface, a contact angle between 90° and 150° indicates a hydrophobic surface and contact angles above 150° indicate a superhydrophobic surface. In other words the higher the contact angle between a solid surface and a water droplet is the less hydrophilic and the more hydrophobic the solid surface is. A more adequate characterization of the wettability properties of surface can be obtained by measuring dynamic contact angles. The contact angle measured by expanding the liquid is referred to as the advancing contact angle and the contact angle formed by contracting the liquid is referred to as the receding contact angle. Known methods to measure a contact angle include direct measurement by goniometers. In the context of this specification a *rolling-off angle* refers to the tilting angle of a surface when a drop of water on this surface starts to roll-off the tilted surface. The smaller a rolling off angle is the less strongly the water drop adheres to the surface.

In some embodiments the colour of the wood material can be measured by commercially available devices such as for example the Chroma Meter CR-200 (MINOLTA, Japan). The colours are recorded in the CIE *L\*a\*b\** colourspace, whereas the dimensions *L\*a\*b\** can be used to calculate the total colour change (ΔE) according to this equation

$$\Delta E = \sqrt{\Delta L^2 + \Delta a^2 + \Delta b^2}.$$

In the context of the present specification, the term *CIE L\*a\*b\* colourspace* refers to an absolute colour space adopted by the International Commission on Illumintaion (CIE) and includes all perceivable colours. It is defined by the dimension *L\** for lightness, *a\** for red/green opponent colours and *b\** for yellow/blue opponent colours. The lightness, *L\**, represents black at *L\**=0, and white at *L\**=100. The red/green opponent colours are represented by *a\**, with green at negative *a\** values and red at positive *a\** values. The yellow/blue opponent colours are represented by *b\**, with blue at negative *b\** values and yellow at positive *b\** values. *Total colour changes* of perceivable colours can be calculated from *L\**, *a\** and *b\** according to the following equation $\left(\Delta E = \sqrt{\Delta L^2 + \Delta a^2 + \Delta b^2}\right)$. The factors *L\**, *a\** and *b\** can be measured with commercially available devices such as for example the Chroma Meter CR-200 (MINOLTA, Japan).

In some embodiments UV exposure is performed with an electrical input of the lamp of 400 W. The lamp has sunlight simulation spectra..

Resistance of wood material to weathering can be measured in wood material subject to accelerated weathering in suitable devices. One such example of a suitable device is the QUV Accelerated Weathering Tester (Q-LAB, United States) that follows the European standard EN 927-6:2006 (E). In some embodiments an exposure cycle of one week consists of a condensation period followed by a sub-cycle of water spray and UV-A 340 nm irradiation as given in Table 1.

Resistance of wood material to mechanical damage can be tested with devices such as a micro scratch tester. These devices allow to physically damage the surface and uppermost layers of the wood material in a defined way. The applied force as well as the depth of penetration can be adjusted precisely. Microscopy can be used to determine the damage done to surface coatings as well as to the surface of the wood material itself.

Simpler and non-quantitative methods to assess the resistance of wood material to mechanical damage are the tape-and-peel test or the blade scratch test. Whereas the former test comprises the use of an adhesive tape that is repeatedly attached and removed to the surface, the latter comprises the use of a blade that is scratched repeatedly on the surface of the wood material. Microscopy techniques can in both cases be used to assess if the damage is only restricted to the directly damaged area or if parts of the surface coating or wood surface is peeling off.

A coating of which at least a single layer, that can impart the properties of the coating to the wood material, remains intact after mechanical insult, such as a tape-and-peel test or a blade scratch test, is deemed resistant to mechanical damage.

According to a third aspect of the invention a wood material particularly comprising the features according to the second aspect of the invention obtainable by a process according to the method of the first aspect of the invention is provided.

In certain embodiments according to the second and third aspect of the invention the wood material is a surface coating for wood material.

In the context of the present specification, the term *wood material* refers to any material comprising wood as an essential part, in particular solid wood products, wood-containing base materials, wood-based materials, semi-finished products or components.

In the context of the present specification, the term *wood* refers to a material comprising the three primary components lignin, cellulose, and hemicellulose. Lignin is a three dimensional aromatic polymer that is part of the cell wall matrix. Cellulose is a non-branching chain of up to several thousand glucose molecules. In contrast hemicelluloses are branched polysaccharides comprising different sugar molecules such as glucose, xylose, mannose, galactose etc. Wood typically comprises about 40 to 50 wt. % of cellulose, about 20 to 35 wt. % of hemicellulose, and about 15 to 30 wt. % of lignin.

In the context of the present specification, the term *solid wood product* refers to timber products, which consist basically of solid wood or solid wood parts. Solid wood describes wood-containing base materials, whose profiles are carved out from a tree trunk and are potentially processed further by cutting/machining, without changing the texture of the wood. Solid wood products can be used to produce components, semi-finished products or products.

In the context of the present specification, the term *wood-containing base materials* refers to all wood-containing materials, which can be used as base materials for the production of wood-based material, components, semi-finished products, products or solid wood products. Wood-containing base materials can include wooden particles or wood pieces, for instance, which are used in the production of chipboards, oriented strand boards or other wood-based materials. Wood-containing base materials are especially used in the production of wood-based materials.

In the context of the present specification, the term *wood-based materials* refers to a material, which is re-assembled and consists of fibres, particles, or layers of wood of different shape, size and thicknesses. The particles can, for example, comprise wood strips, wood chips or wood fibers of the same or of different types of wood, of a certain size or of different sizes.

In the context of the present specification, the term *semi-finished products* refers to base material products, for instance a plate, a pole or a tube, which can be processed further to the actual finished product (the final product). A semi-finished product can include an appropriately cut piece of solid-wood or comprise different wood-containing base materials. According to the invention, a semi-finished product can also be wood chips or wood stripes.

In the context of the present specification, the term *component* refers to a part (for instance a solid wood product, a wood-containing base material and/or a wood-based material) of a larger complex. A complex can be a building or a storage product, like a showcase, or a part of furniture. The components (in particular different components) can form the complex together, given an appropriate composition.

Wherever alternatives for single separable features such as, for example, a treatment duration or temperature, a solution component or immersion duration are laid out herein as "embodiments", it is to be understood that such alternatives may be combined freely to form discrete embodiments of the invention disclosed herein.

The invention is further illustrated by the following examples and figures, from which further embodiments and advantages can be drawn. These examples are meant to illustrate the invention but not to limit its scope.

Short description of the figures

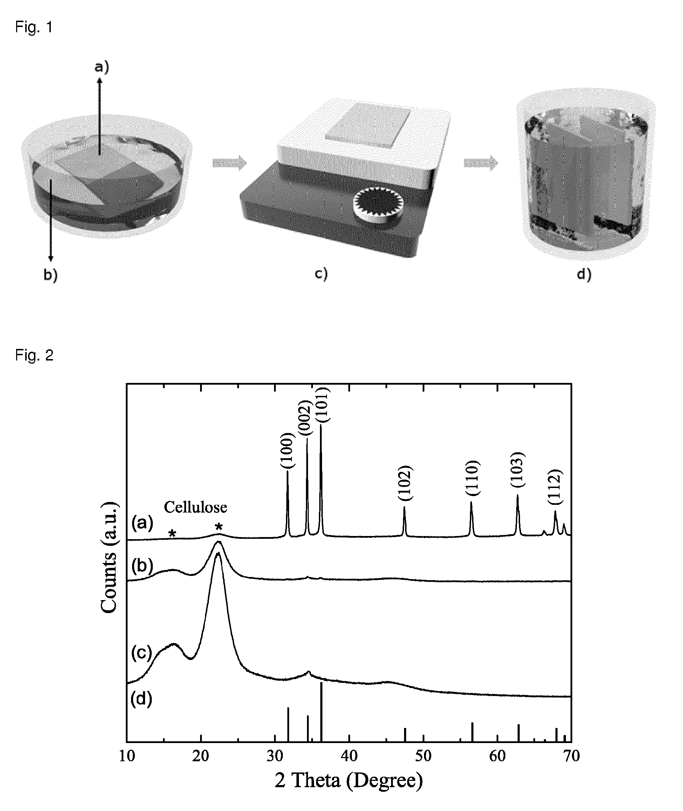

Fig. 1 shows a schematic illustration of the chemical bath deposition process for wood surface modification. a) Norway spruce, b) seeding solvent: ZnO, $NH_3 \cdot H_2O$, c) baking at 110°C, d) growth at 80°C; Growth solution 1: ZnO, $NH_3 \cdot H_2O$, Ammonium citrate and $NH_4NO_3$; Growth solution 2: $Zn(NO_3)_2$, HMTA

Fig. 2 shows the X-ray diffraction pattern of Norway spruce with a dense ZnO coating (a), Norway spruce with a seed layer (b), and Norway spruce without any treatment (c). The reference powder diffraction pattern of ZnO (JCPDS 36-1451) is shown for comparison (d). Asterisk (*) denotes the position of characteristic cellulose peaks.

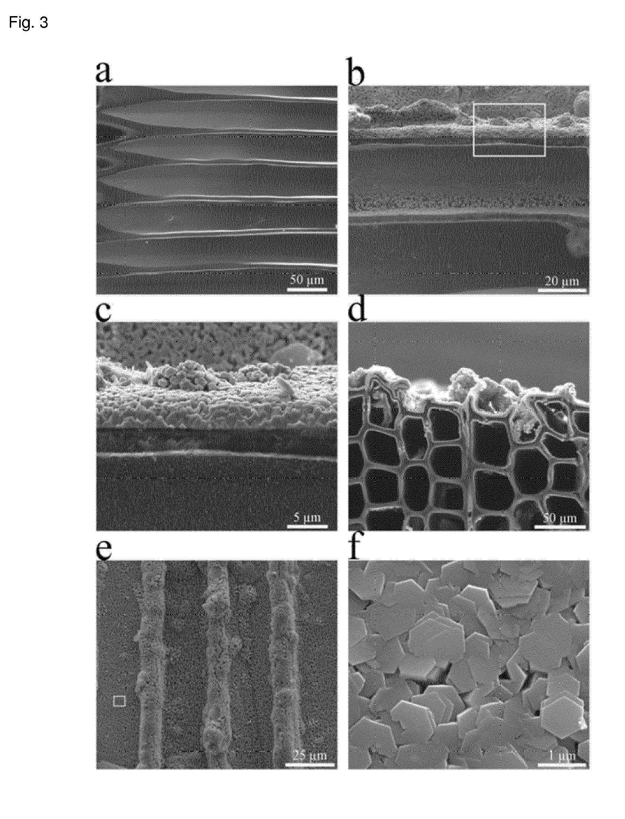

Fig. 3 shows (a) SEM images of the radial plane of Norway spruce acquired from the early wood region; (b) SEM images of the wood cell structures with ZnO coating; (c) High magnification SEM image acquired from the squared area shown in b; (d) The SEM image of transverse plane of spruce wood with ZnO coating on the tangential plane; (e) SEM acquired from the tangential plane of spruce wood with ZnO coating, and (f) the high magnification SEM image acquired from the squared area shown in b.

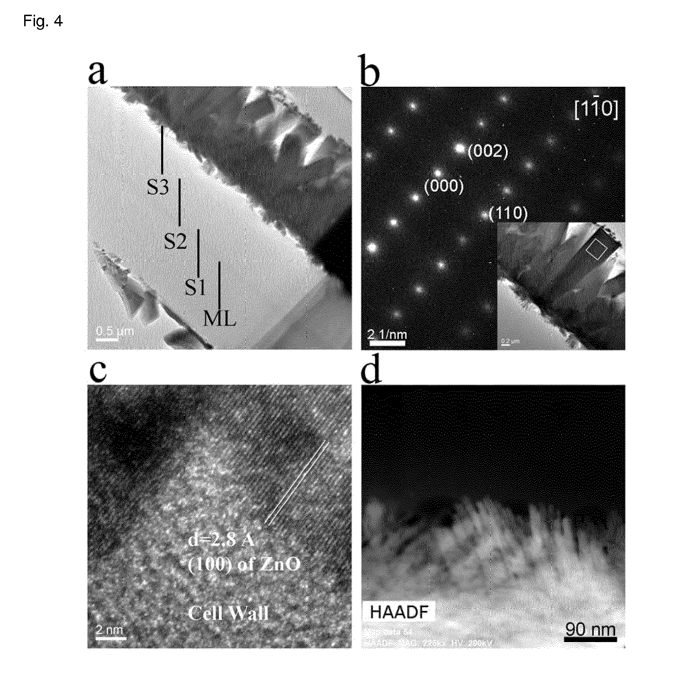

Fig. 4 shows (a) Low magnification TEM image of wood lamina with ZnO coating prepared by focus ion beam; ML=middle lamella, S1=secondary wall S1 1, S2=secondary wall S2 2, S3=Secondary cell wall S3. (b) Selective area electron diffraction (SAED) pattern from the square area noted in the inset; (c) High resolution TEM (HRTEM) image from the ZnO and wood cell wall interface; (d) HAADF-STEM image acquired from the ZnO and wood cell wall interface.

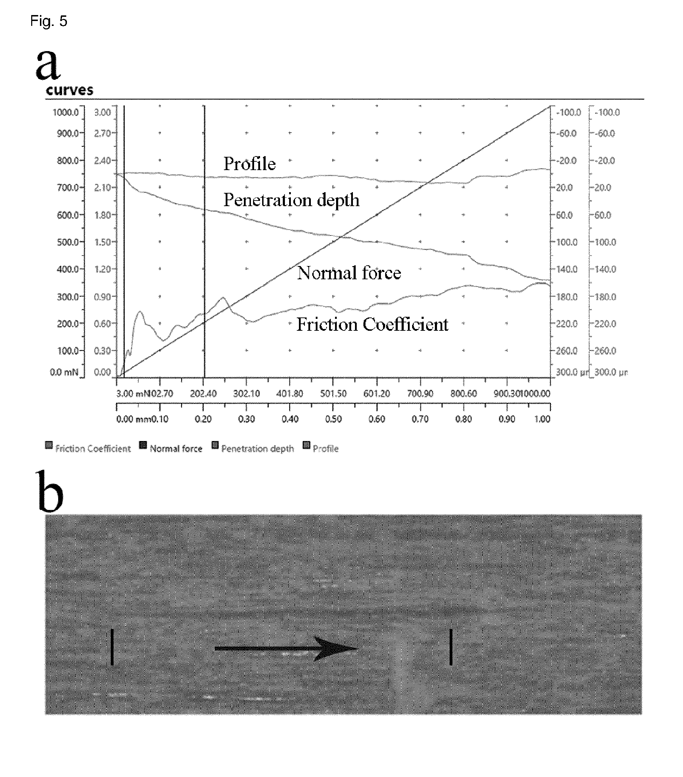

Fig.5 shows (a) Applied parameters and feedback curves of the micro scratch test. (b) Optical microscopy image acquired from the dense ZnO coating wood surface after scratch test. The scratch profile started from left to right end was marked with black notes.

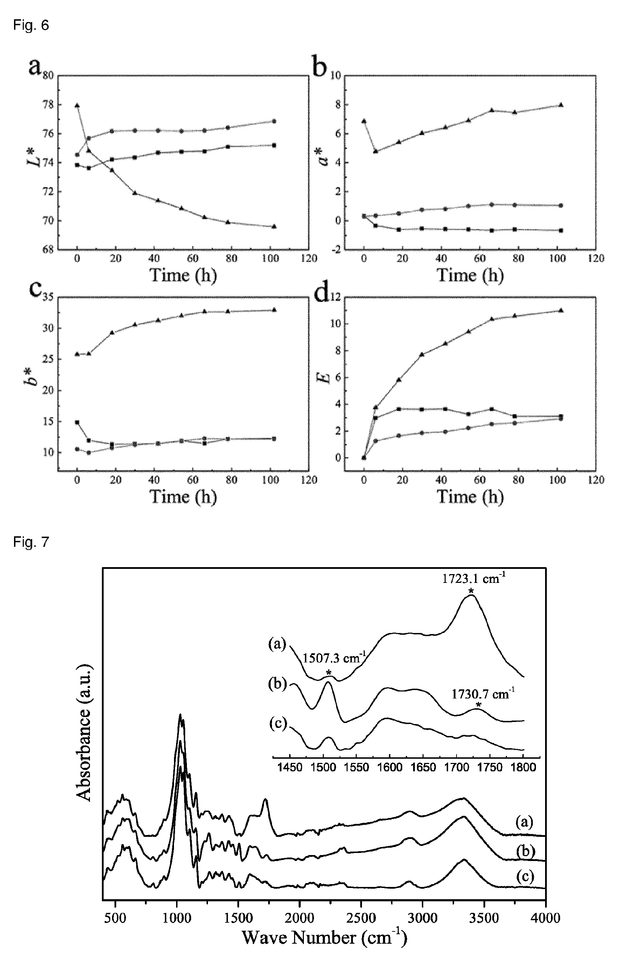

Fig. 6 shows (a) Dependence of lightness factor ($L^*$) on the irradiation time. (b) The variation of the redness factor ($a^*$) of spruce versus the irradiation time. (c) The variation of yellowness ($b^*$) of the samples as a function of irradiation time. (d) Total color change difference $\Delta E$ as a function of irradiation time. (■) spruce with dense ZnO coating; (●) spruce with ZnO nanorod array coating; (A) spruce without any modification.

Fig. 7 shows FT-IR spectra of spruce wood before (b) and after (a) UV irradiation, as well as the dense ZnO coating spruce wood after UV irradiation (c); inset: zoom of the carbonyl and aromatic absorption region.

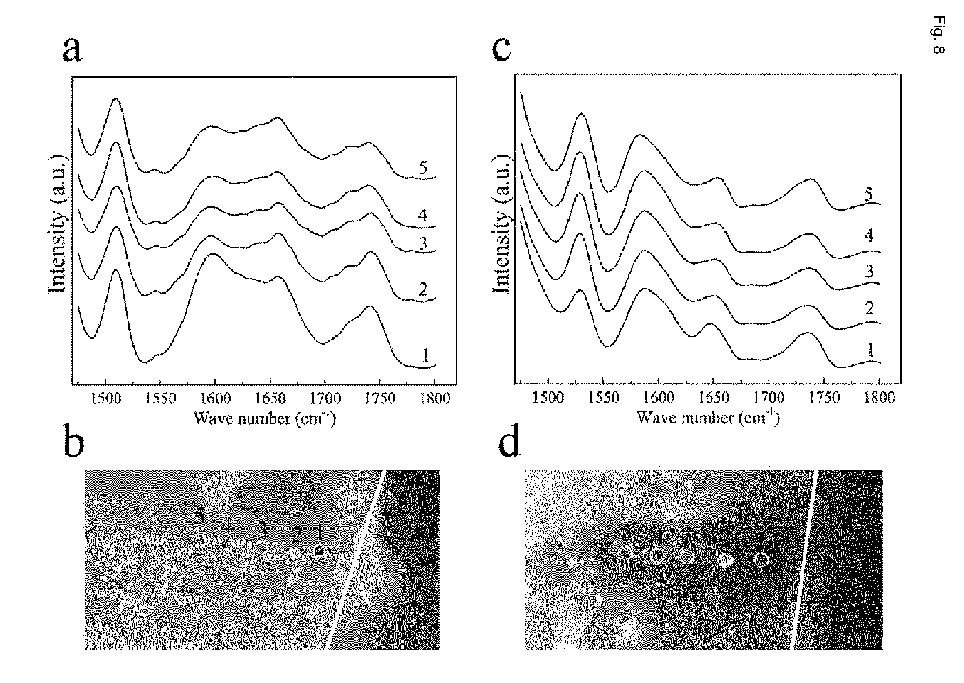

Fig. 8 shows (a) FT-IR spectra acquired from the cross section of spruce wood. The spectra were acquired along middle lamella from the most top (point 1) to the third cell layer (point 5) as noted in (b). (c) FT-IR spectra acquired from the cross section of ZnO coating spruce wood after 102 h UV treatment. The spectra were acquired along middle lamella from the most top (point 1) to the third cell layer (point 5) as noted in (d)

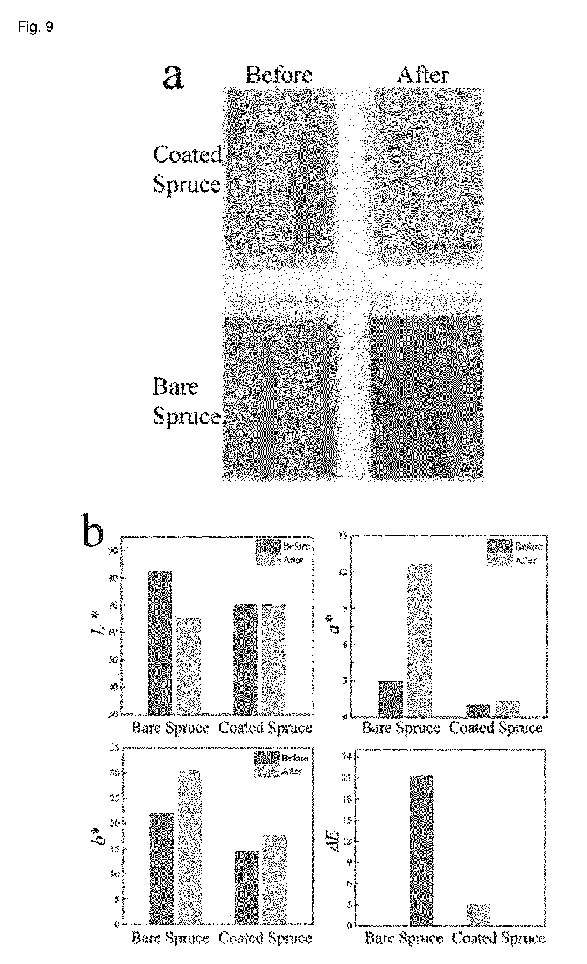

Fig. 9 shows (a) Changes in the appearance of modified and non-modified spruce wood during the accelerated weathering test. Notably the bare spruce shows marked cracks in the surface after weathering. In contrast, no cracks can be observed in the treated wood material after weathering. (b) Difference of lightness ($L^*$), redness ($a^*$), yellowness ($b^*$) as well as total colour changes ($\Delta E$) in the surface of spruce wood with or without modification during weathering test.

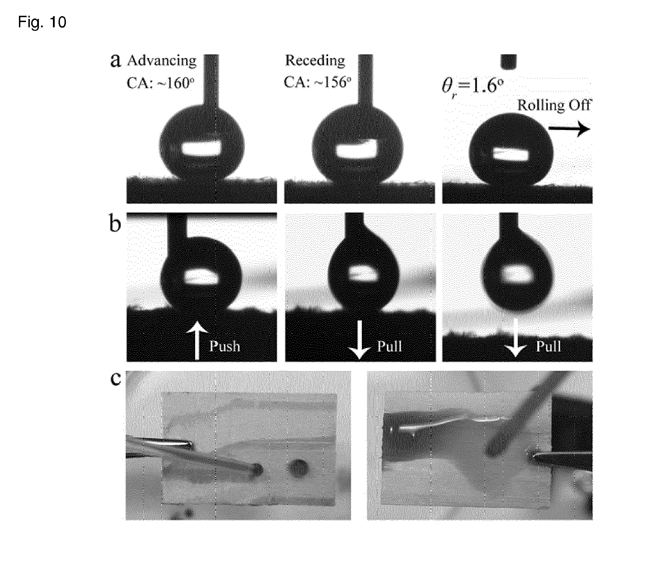

Fig. 10 shows water repellency. (a) Snapshots from the measurement of advancing and receding contact angles and roll-off of a water droplet measured on the ZnO nanorods arrays modified wood surface. (b) Extremely low water adhesion confirmed by push and pull of a water droplet to the superhydrophobic surface. (c) Behavior of coffee droplets on the ZnO modified superhydrophobic wood surface (left) and bare wood surface (right), respectively.

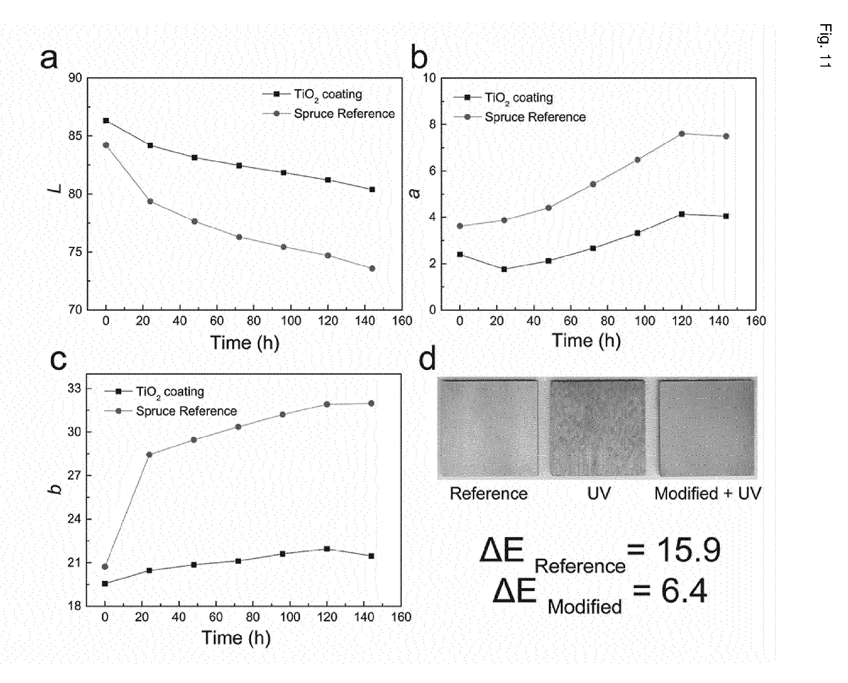

Fig. 11 shows changes of a) lightness (L*), b) redness (a*), c) yellowness (b*) in the surface of spruce wood with ($TiO_2$ coating, ■) or without modification (spruce reference, ●) during UV exposure for 144 hours. d) Changes in the appearance of modified ($TiO_2$ coating) and non-modified spruce wood (spruce reference) during UV exposure for 144 hours. Notably the bare spruce shows much higher total colour changes ($\Delta E=15.9$) as compared to modified spruce ($\Delta E=6.4$).

Examples

The technical problem in wood surface modification is how to cover the rough wood surface (uneven topography with lumen and cut-open cells wall) with a continuous and complete coating of ZnO. A strong adhesion between the inorganic coating and wood surface is necessary to prevent the separation of the coating. Finally, the inorganic coating should possess a high degree of crystallinity to achieve a certain transparency for aesthetic reasons and to avoid etching underwater spraying.

In this specification, a novel seeding method is disclosed to modify the wood surface with a thin seeding layer by dipping wood material into a basic solution of Zinc Oxide before drying. This liquid based seeding method enables to seed the rough wood surface completely and to form a strong interface between the seeding layer and the wood surface. By adjusting the amount of ammonium citrate in the growth process, the synthesis of ZnO nanorod arrays or dense coatings can specifically be selected. The chemical bath deposition process is illustrated in Fig. 1.

Example 1:

The process of wood treatment with ZnO in basic solvent according to the invention comprises the following steps:

I. ZnO coating

1) Preparation of basic solution of zinc oxide containing 50mM ZnO and 5M $NH_3$ by magnetic stirring assisted solubilisation (dissolving solid zinc oxide in aqueous solution of ammonia), the as-prepared solution was denoted as seeding solvent. Ammonium hydroxide (28 wt%; Alfa Aesar) was used to prepare basic solution.

2) Preparation of the growth solution containing $NH_4NO_3$ (8.02g, Sigma Aldrich, p.a. grade), ammonium citrate (0.195g, Alfa Aesar, p.a. grade) and ZnO powder (8.145g, Sigma Aldrich, p.a. grade) and 132 ml of $NH_4OH$ (28 wt%, Alfa Aesar). The components were loaded into a plastic bottle before pouring 18 MΩ cm deionized water until the total volume reached 2 L. The growth solution was stirred for 12 hours and stored at room temperature until usage. 200 mL growth solution was filtered (1 μm glass fiber filters) into a glass flask followed by adding 0.1356 g of ammonium citrate.

3) Spruce wood slices (radial (R) × tangential (T) × longitudinal (L) dimensions: 5×25×40 mm) were firstly ultrasonically cleaned in a mixed solution of ethanol and acetone for 30 min, and then stored in the artificial climate room with a temperature of 20°C and a relative humidity of 65%.

4) Dipping the wood slice into the seeding solvent described in step 1) for 3 minutes before transferring it into the oven at 110°C for 2 min. In order to obtain a dense and continuous ZnO coating, the seeding procedure was repeated for three times to ensure that the wood surface was completely seeded.

5) After pre-heating the growth solution at 90°C for 15 min, the seeded spruce slices were immersed into the growth solution. Chemical bath deposition was carried out at 90°C for 150 minutes. After the chemical bath deposition, the wood samples were washed with water and dried in an oven at a temperature of 65°C for 12 hours.

II. UV and weathering stability assessment

A UV curing chamber (UVACUBE 400, Honle Goup) was used as a light source for the short-time irradiation to assess the UV protection efficiency of the coating.

Exposure of the wood coating to artificial weathering using fluorescent UV lamps and water was carried out in the QUV Accelerated Weathering Tester (Q-LAB, United State) following the European standard EN 927-6:2006 (E). An exposure cycle of one week consists of a condensation period followed by a sub-cycle of water spray and UV-A 340 irradiation as given in Table 1.

**Table 1: Exposure cycle**

| Step | Function | Temperature | Duration | Condition |
|---|---|---|---|---|
| 1 | Condensation | (45±3) °C | 24 h | |
| 2 | Subcycle Step 3+4 | | 144 h consisting of 48x cycles of 3 h consisting of steps 3 and 4 | |
| 3 | UV | (60±3) °C | 2.5 h | Irradiance set point 0.89 W/(m$^2$nm) at 340 nm |
| 4 | Spray | | 0.5 h | 6 L/min to 7 L/min, UV off |

Colour evaluation of the wood samples before and after UV exposure and water spraying were determined in the CIE $L*$, $a*$ and $b*$ system with the Chroma Meter CR-200 (MINOLTA, Japan). $L*$ represents the lightness from black (0) to white (100), while $a*$ and $b*$ were the chromaticity indices where $+a*$ was the red, $-a*$ was the green, $+b*$ was the yellow, $-b*$ was the blue directions. The total colour change was defined according to equation (1):

$$\Delta E = \sqrt{\Delta L^2 + \Delta a^2 + \Delta b^2} \qquad \text{(equation 1) Characterization of total colour changes}$$

The ZnO coating of the wood surface was characterized by x-ray diffraction (XRD) (Fig. 2). Spruce wood exhibits a couple of strong diffraction peaks at 16.4° and 22.4°, which can be attributed to the cellulose crystals inside the wood structure. The XRD pattern of wood with a seeding layer, has no diffraction peak belonging to ZnO. However, the diffraction peaks of cellulose crystals are suppressed. It reveals that the wood surface was covered with an amorphous ZnO seeding layer after dipping into the zinc oxide dissolved ammonia solution and heat treatment. After the chemical bath deposition process, a series of diffraction peaks assigned to hexagonal ZnO (JCPDS 36-1451) were observed. On the other hand, the diffraction peaks of cellulose crystals almost disappeared, because the wood surface was covered by a continuous, dense and highly crystalline ZnO film. The high crystallinity of ZnO coating contribute to their excellent durability under weathering conditions.

The dense and continuous ZnO film coating on the wood surface was further investigated by SEM from radial section and cross section. It demonstrates that the wood surface is covered with a conformal ZnO film which also covers the lumen surface of the first cell layer (Fig. 3a and b). A similar result can be observed from the SEM image acquired from the transverse plane which indicates that ZnO film follows the topography of the rough wood surface (Fig. 3c). The higher magnification SEM images demonstrate that the wood surface is covered by a dense and continuous ZnO layer with an average thickness of about 3.5 μm, while the surface of the inner, intact lumen of the most top cell layer is also covered by ZnO film with a thickness of about 600 nm (Fig. 3d). The latter indicates that the precursor solution penetrated through the outermost wood cell wall during the CBD process. The morphology of the ZnO coating surveyed from the tangential plane demonstrates that the ZnO crystal is highly crystalline with a flat end face (Fig. 3e,f). ZnO crystals are merging together with twinned boundaries. Low magnification TEM imaging demonstrates that ZnO coating is tightly covering the cell wall surface without any crevices (Fig. 4a). SAED pattern indicates that the dense ZnO film grows, as expected, along the [001] wurtzite direction (Fig. 4b). From the HRTEM image of the cell wall and ZnO interface (Fig. 4c), (100) lattice planes of hexagonal ZnO as well as the diffraction contrast image from cellulose crystal in the wood cell wall were observed. The lattice-resolved image indicates that the wood cell wall and ZnO coating interface is fused.

From the HAADF-STEM image (Fig. 4d), the seeding layer that is in direct contact with the cell wall is made of dendritic crystal whiskers, which allows for strong adherence to the wood cell wall.

A micro scratch tester was used to characterize the practical adhesion failure of the ZnO coating with a 10 $\mu$m tip in 1 mm length (Fig. 5). The friction coefficient increased sharply in the first 50 $\mu$m, where the tip penetrated into a depth of about 25 $\mu$m. In this stage, the tip was mainly in contact with the ZnO coating. After that, the increment in the friction coefficient is minor, because the tip had cut through the coating and mainly contacted with the wood substrate which was soft compared to the ZnO coating. The micro tip penetrated into a depth of about 160 $\mu$m as the loading increased from 3 mN to 1000 mN. However, the optical microscopy image of the wood surface after the scratch test, reveals no obvious peeling off from the ZnO coating. As discussed above, the ZnO coating had a strong interaction with the wood substrate because of the coordination effect. Therefore, the ZnO coating will be shoved off along the grain boundary following substrate when the tip penetrated into wood instead of peeling off. It reveals that the coating has a strong adhesion to the wood surface, and is robust to mechanical scratch. A non-quantitative tape-and-peel test and a blade scratch were used to evaluate the coating adhesion at the macro scale. The ZnO coating followed the surface topography of the wood surface, which displayed almost no change after 100 cycles of the tape-and-peel test. In the harsher blade scratch, the continuous and dense ZnO coating was grinded into rough particles and the surface became white. However, the ZnO coating was still on the wood surface after the brushing with compressed air. The mechanical property characterization demonstrates that the ZnO coating has strong adhesion and can withstand most of the mechanical damage in outdoor application.

The UV protection efficiency of the modified wood was assessed by alternating UV exposure and color measurement (Fig. 6). During the UV exposure, the unmodified sample lost lightness from 77.9 to 69.5, while the modified sample experienced a minute increment from 73.9 to 75.2 (Fig. 6a). The redness index ($a^*$) of the unmodified sample underwent a decrease in the first 6 h and then increased up to 8.0 (Fig. 6b). In comparison, the value of $a^*$ decreased from 0.34 to -0.54 and then remained rather constant during the irradiation for the dense ZnO coating sample. Fig. 6c demonstrates that the non-modified spruce has an apparent yellow shift with an increment in the value of $b^*$ from 25.8 to 32.9. However, for the sample with dense ZnO coating, $b^*$ slightly decreased from 14.8 to 11.36 in the first 18 h, and further experienced a slow increment to finally reach 12.3. The total color difference $\Delta E$ as a function of the irradiation time is given in Fig. 6d. $\Delta E$ shows a systematic trend of increase with increasing irradiation time for unmodified spruce, which shows a total color change of 11 after 102 hours of UV exposure. In comparison, the total color change of the modified sample is clearly limited (about 3.0). These results demonstrate that a wood surface with a dense ZnO coating is sufficiently protected against color changes induced by UV exposure. For comparison between the two nanostructure morphologies the UV-stability of spruce wood with a ZnO nanorod array is shown.

The change in chemical structure of wood was further analyzed by FT-IR spectroscopy (Fig. 7). Fig. 7a and b indicates that the absorption of UV light yields significant intensity changes in the FT-IR spectra of the wood surface without coating. The characteristic aromatic lignin band at 1507.3 cm$^{-1}$ was absent after 102 h UV exposure, which is linked to the strong formation of the new carbonyl absorption centered at 1723.1 cm$^{-1}$ (non-conjugated aliphatic carbonyls). It reveals that UV irradiation induced the photooxidation of lignin on the spruce wood surface without modification. In order to analyze the change in the chemical structure of the ZnO coating spruce after UV exposure, an experiment was carried out by removing the coating layer via ultrasonic treatment in 2 wt% HCl. The FT-IR spectrum was acquired from the surface after drying in the oven at 65°C for 3 h. Although, the aromatic lignin band at 1507.3 cm$^{-1}$, as well as the C=O stretch of conjugated or aromatic ketones (between 1600-1700 cm$^{-1}$) have a slight decrease, there is no increment in the intensity between 1700-1750 cm$^{-1}$ (Fig. 7). It reveals that the UV induced photooxidation is suppressed by the ZnO coating. The decline in the intensity of aromatic peak only happened in the outmost layer. It was further confirmed by FT-IR microscopy which was applied to study the lignin degradation on the cross section (Fig. 8).

Accelerated weathering tests were carried out based on the European standard: EN 927-6:2006. As a result, there is not only a colour change but also cracking observed from the bare spruce slice after the weathering test (Fig. 9a). However, the samples with surface coating, experience almost no colour change except a slight surface haze. This indicates that the ZnO coating forms a transparent protective coating, which serves not only as a UV blocking, but also as a waterproofing layer which reduces dimensional changes of the wood and as a result the occurrence of cracks due to weathering. Accurate colour change was quantified by the CIE $L^*$, $a^*$ and $b^*$ system with the Chroma Meter (Fig. 9b).

III. Concept behind the invention

Without wishing to be bound by theory the disclosed invention takes advantage of the coordination effect of $Zn[(OH)_x(NH_3)_y]^{2-x}$ complexes to hydroxyl, carbonyl groups of lignocellulose to coat the uneven wood surface with conformal ZnO film via chemical bath deposition. The morphologies of ZnO coatings can be selectively controlled from rough nanorods to a continuous and dense film using different capping agents. The high crystallinity and continuity of the ZnO crystals in the dense film not only endows the coating with effective UV blocking properties, but also makes it more stable during weathering. The dense film renders the coating more transparent for preserving the aesthetic appeal of the wood surface. The study with advanced S/TEM indicates a wood surface interlocking with ZnO dendritic crystal whisker at the interface, which results in the strong interaction between the inorganic coating and the wood biopolymer.

Example 2

The process of wood material preparation using Zinc nitrate hexahydrate and hexamethylenetetramine (HMTA) and including a hydrophobization step according to the invention comprises the following steps:

I. ZnO coating

1) Preparation of basic solution of zinc oxide containing 50mM ZnO and 5M $NH_3$ by magnetic stirring assisted solubilisation (dissolving solid zinc oxide in aqueous solution of ammonia), the as-prepared solution was denoted as seeding solvent. Ammonium hydroxide (28 wt%; Alfa Aesar) was used to prepare basic solution.
2) Preparation of the growth solution containing 80g $Zn(NO_3)\cdot6H_2O$ and 35g hexamethylenetetramine (HMTA) were loaded into a stainless steel container before pouring deionized water until the total volume reach 6L.
3) Spruce wood slices (radial (R) $\times$ tangential (T) $\times$ longitudinal (L) dimensions: 15$\times$1.5$\times$65 cm) were cut and stored in the artificial climate room with a temperature of 20°C and a relative humidity of 65%.
4) Dipping the wood slice into the seeding solvent described in step 1) for 5 minutes before transferring it into the oven at 80°C for 10 minutes. In order to obtain a dense and continuous ZnO coating, the seeding procedure was repeated for three times to ensure that the wood surface was completely seeded.
5) After pre-heating the growth solution to 45°C, two seeded spruce slices were immersed into the growth solution. Chemical bath deposition was carried out at 85°C for 120 minutes. After the chemical bath deposition, the wood samples were washed with water and dried in an oven at a temperature of 60°C for 2 hours. The same procedure was repeated one more time to obtain a high quality ZnO coating.

II. Preparation of hydrophobic surface-layer

1) Preparation of a hydrophobic solution containing 5mM stearic acid in ethanol solution,
2) Immersing the wood slices obtained from process I. into the hydrophobic solution for 12 h.
3) The wood slices were subsequently put in to an oven and heated up to 65°C for 2 h to secure the strong bonding of hydrophobic molecules.

Example 3:

The process of wood material preparation with ZnO including the addition of a $SiO_2$ blocking layer and a hydrophobization step according to the invention comprises the following procedures:

I. ZnO coating

1) Preparation of basic solution of zinc oxide containing 50mM ZnO and 5M $NH_3$ by magnetic stirring assisted solubilisation (dissolving solid zinc oxide in aqueous solution of ammonia), the as-prepared solution was denoted as seeding solvent. Ammonium hydroxide (28 wt%; Alfa Aesar) was used to prepare basic solution.
2) Preparation of the growth solution containing $NH_4NO_3$ (8.02g, Sigma Aldrich, p.a. grade), ammonium citrate (0.195g, Alfa Aesar, p.a. grade) and ZnO powder (8.145g, Sigma Aldrich, p.a. grade) and 132 ml of $NH_4OH$ (28 wt%, Alfa Aesar). The components were loaded into a plastic bottle before pouring 18 M$\Omega$ cm deionized water until the total volume reached 2 L. The growth solution was stirred for 12 hours and stored at room temperature until usage. 200 mL growth solution was filtered (1 $\mu$m glass fiber filters) into a glass flask followed by adding 0.1356 g of ammonium citrate.
3) Spruce wood slices (radial (R) $\times$ tangential (T) $\times$ longitudinal (L) dimensions: 5$\times$25$\times$40 mm) were firstly ultrasonically cleaned in a mixed solution of ethanol and acetone for 30 min, and then stored in the artificial climate room with a temperature of 20°C and a relative humidity of 65%.
4) Dipping the wood slice into the seeding solvent described in step 1) for 3 minutes before transferring it into the oven at 110°C for 2 min. In order to obtain a dense and continuous ZnO coating, the seeding procedure was repeated for three times to ensure that the wood surface was completely seeded.

5) After pre-heating the growth solution at 90°C for 15 min, the seeded spruce slices were immersed into the growth solution. Chemical bath deposition was carried out at 90°C for 150 minutes. After the chemical bath deposition, the wood samples were washed with water and dried in an oven at a temperature of 65°C for 12 hours.

II. Preparation of $SiO_2$ blocking layer

1) Preparation of stabilizing solution containing tetraethyl orthosilicate (32 μL), water (80 mL), ethanol (20 mL) and ammonium hydroxide (1 mL, 25%).
2) Immersing the wood slices obtained from process I. into the stabilizing solution for a duration of 3 hours at room temperature.

III. Preparation of hydrophobic surface-layer

1) Preparation of a hydrophobic solution containing 5mM stearic acid in ethanol solution,
2) Immersing the wood slices obtained from process II. into the hydrophobic solution for 12 h.
3) The wood slices were subsequently put in to an oven and heated up to 65°C for 2 h to secure the strong bonding of hydrophobic molecules.

Compared with existing technologies, the advantages of this invention include the following points:

1) The treatment of wood material as described is facile, mild and economic. Both the seeding and growth process can be finished in a short time compared to current technologies.
2) The treatment method via a facile aqueous based chemical bath deposition process was carried out in a non-toxic and mild condition (without exceeding temperature of 120°C at any step).
3) The morphology of the ZnO coating can be tailored by adjusting the concentration of ammonium citrate, to selectively synthesize ZnO nanorods array coatings or dense ZnO film coatings.
4) The coating is mechanically robust and hardly separated from the wood surface.
5) Both UV protection and superhydrophobic wood surface modification are combined in this invention.
6) The disclosed method is efficient and can be easily scaled-up for large scale surface modification, in order to make wood more reliable in building facade applications.

Example 4:

*Protection of wood surface by $TiO_2$*

The coating process contains the hydrolysis initiated by the nucleophilic ligands in wood and polymerization reactions of the precursor, which is titanium tetraisopropoxide (TTIP) in this report. 2 mL TTIP was injected into 20 mL ethanol solution. Then, 2 pieces of spruce sample (50 × 50 × 5mm in longitudinal × tangential × radical in dimension) were immersed into the mixed solution for 24 hours at room temperature. The samples were removed from the solution followed by drying in the oven at 65°C for 2 hours, 120°C for 1 hour and 180°C for 0.5 hour.

*UV stability*

The UV protection effect of the modified sample was assessed by UV exposure in the UV chamber combined with color measurement. As shown in Figure 11a and b, the bare spruce exhibits larger change in lightness and becomes more red compared to the modified counterpart. The most obvious difference was observed in the yellowing index (Figure 11c). The yellowing index (b) increases from 20 to 32 after 144 hours UV exposure in the unmodified sample, while it increase from 19.5 to 21.5 in the modified one. The appearance and total color change of the samples with or without UV exposure was shown in Figure 11 d.

**Claims**

1. A method for treatment of wood material comprising

   a) a first treatment step comprising the steps of

      i. provision of a first solution comprising:

         - zinc oxide in aqueous solution, or
         - titanium(IV) isopropoxide (TTIP) and an organic solvent, in particular an alcohol, more particular ethanol; and

      ii. immersion of said wood material into said first solution; and
      iii. drying of said wood material;

   b) in case of the first solution comprising zinc oxide the method additionally comprises a second treatment step comprising the steps of:

      i. provision of a second solution comprising a zinc compound; and
      ii. immersion of said wood material into said second solution; and
      iii. drying of said wood material.

2. The method for treatment of wood material according to claim 1, wherein in case of the first solution comprising zinc oxide:

   - the first solution has a pH > 7, in particular a pH 8-14, more particular a pH 9-13, most particular a pH 10 to 12, and/or
   - the second solution has a pH ≥ 7, in particular a pH 7-14, more particular a pH 8-13, most particular a pH 10 to 12.

3. The method for treatment of wood material according to any one of the preceding claims, wherein the first solution comprises

   - zinc oxide with a concentration of 30 to 60mM ZnO, in particular 40 to 55mM ZnO, more particular 40 to 50mM ZnO and most particular 50mM ZnO or
   - TTIP with a concentration from 1 wt% to 10 wt%, in particular 2 wt% to 8 wt%, more particular 4 wt% to 6 wt%

4. The method for treatment of wood material according to any one of the preceding claims, wherein.

   - said wood material is immersed in the first treatment step into the first solution:

      - in case of the first solution comprising zinc oxide for 30 seconds up to 5 minutes, in particular 3 minutes to 5 minutes, more particular 5 minutes, and
      - in case of the first solution comprising titanium(IV) isopropoxide for 12 hours up to 36 hours, in particular 14 hours to 24 hours, more particular 24 hours,

   and/or

      - said wood material is immersed in the second treatment step into the second solution for at least 5 minutes, in particular 5 minutes to 240 minutes, more particular 30 minutes to 150 minutes, most particular 120 minutes, and/or
      - the second solution has a temperature of 70°C to 110°C, in particular 70°C to 90°C, more particular 85°C.

5. The method for treatment of wood material according to any one of the preceding claims, wherein drying of said wood material is performed:

   - in the first treatment step

      - in case of the first solution comprising zinc oxide at a temperature of 80°C to 110°C, in particular 90°C to 110°C, more particular 110°C, for at least 2 minutes, in particular 2 to 30 minutes, more particular 10 minutes, or

- in case of the first solution comprising titanium(IV) isopropoxide drying of said wood material is performed in in three steps with increasing temperatures after each step with temperatures between 50°C and 200°C and a drying time between 15 minutes and 3 hours in each of the three steps; and/or

- in the second treatment step at a temperature of 50°C to 80°C, in particular 60°C to 80°C, more particular 65°C for at least 2 hours, in particular 2h to 16h, more particular 4h to 12h.

6.  The method for treatment of wood material according to any one of the preceding claims, wherein the zinc compound of said second solution is selected from zinc oxide, zinc nitrate and zinc acetate, particular zinc nitrate.

7.  The method for treatment of wood material according to any one of the preceding claims, wherein:

- in case said zinc compound is zinc oxide the second solution additionally comprises ammonium hydroxyl and/or at least one ammonium salt, and
- in case said zinc compound is zinc nitrate or zinc acetate, the second solution additionally comprises hexamethylentetramine and/or at least one ammonium salt.

8.  The method for treatment of wood material according to any one of the preceding claims, wherein the second solution comprises:

- zinc oxide with a concentration of 40 to 65 mM, in particular 40 to 55 mM, more particular 50 mM, or
- zinc nitrate with a concentration of 40 to 65 mM, in particular 40 to 55 mM, more particular 50 mM, or
- zinc acetate with a concentration of 40 to 110 mM, in particular 50 to 100 mM.

9.  The method for treatment of wood material according to any one of the preceding claims in case of the first solution comprising zinc oxide further comprising a stabilization step after step b) comprising the steps of:

i. provision of a stabilizing solution comprising a precursor of $SiO_2$,
ii. immersion of said wood material into said stabilizing solution, wherein the duration of immersion into the stabilizing solution is 1h to 6h, in particular 2h to 5h and more particular 3h to 4h.

10.  The method for treatment of wood material according to claim 9, wherein the stabilizing solution comprises:

- tetraethyl orthosilicate, and/or
- ammonium hydroxide, and/or
- water and organic solvent, in particular water and alcohol, more particular water and ethanol.

11.  The method for treatment of wood material according to any one of claims 9 to 10, wherein the volume ratios in the stabilization solution of:

i. water to organic solvent ranges from 20:100 to 20:70, and/or
ii. water to ammonium hydroxide ranges from 20:0.5 to 20:1.5, and/or
iii. water to tetraethyl orthosilicate range from 20000:10 to 20000:60.

12.  The method for treatment of wood material according to any one of the preceeding claims further comprising a hydrophobization step comprising the steps of:

i. provision of a hydrophobic solution comprising a hydrophobic molecule, in particular a long alkyl chain thiols, organic silanes, fatty acids, aromatic azide or fluorinated organic silane molecules, in particular the hydrophobic molecule is selected from:

- 1H,1H,2H,2H-Perfluorooctyltriethoxysilane,
- Trichloro (1H,1H,2H,2H-perfluorooctyl) silane,
- methyltrichlorosilane,
- decyltrichlorosilane,
- 3,3,4,4,5,5,6,6,7,7,8,8,8-tridecafluorooctyl acrylate,

- 1-Dodecanethiol,
- Trimethoxy(octyl)silane and
- stearic acid;

ii. immersion of said wood material into said hydrophobic solution,
iii. heat treatment of said wood material.

13. The method for treatment of wood material according to any one of claims 12 and 13, wherein:

- the immersion time is between 0.5h to 12h, in particular 2h to 12h more particular 4h to 12h, most particular 12h and/or
- the heat treatment is performed at a temperature of 50°C to 80°C, in particular 60°C to 70°C, more particular 65°C, for a duration of 0.5 hours to 3 hours, in particular 3 hours

14. A wood material **characterized by** the visibility of the natural appearance of the surface of said wood material and at least one of the following properties:

I. the resistance to UV induced changes in perceivable colour, wherein the said wood material has no decrease in lightness (L*) after at least 100 hours of UV exposure, and/or;

II. the resistance to UV induced changes in perceivable colour, wherein the said wood material has a change of red/green opponent colours (a*) of less than 2, in particular less than 1, after at least 100 hours of UV exposure, and/or

III. the resistance to UV induced changes in perceivable colour, wherein the said wood material has a change of yellow/blue opponent colours (b*) of less than 5, in particular less than 3, after at least 100 hours of UV exposure, and/or

IV. the resistance to UV induced changes in perceivable colour, wherein the said wood material has a total colour change ($\Delta E$) of less than 4, in particular less than 3, after at least 100 hours of UV exposure, and/or

V. the resistance to weathering induced changes in perceivable colour, wherein the said wood material has a total colour change ($\Delta E$) of less than 4, in particular less than 3, after at least 100 hours of accelerated weathering as defined in table 1 and/or;

VI. the absence of X-ray diffraction peaks at degrees two-theta having a margin of error +/- 0.2 degrees 2-theta: 16.4° and 22.4°; and/or

VII. the counts for the X-ray diffraction peak at degrees two-theta 22.4° having a margin of error +/- 0.2 degrees 2-theta is below 20000, in particular below 15000, more particular below 13000; and/or

VIII. the presence of X-ray diffraction peaks at degrees two-theta having a margin of error +/- 0.2 degrees 2-theta: 31.77°, 34.42°, 36.25°, 47.54° and 62.86°, and/or;

IX. the resistance to UV induced degradation of lignin, wherein the band in the FT-IR spectrum at 1507.3 cm$^{-1}$ is not significantly changed after at least 100 h of UV exposure, and/or;

X. the resistance to an UV induced increase in the band in the FT-IR spectrum at 1723.1 cm$^{-1}$ after at least 100 h of UV exposure, and/or

XI. superhydrophobic properties, wherein the advancing contact angle of a water drop is between 150° and 165°, in particular between 155° and 160°, most particular 160° and the receding contact angle of a water drop is between 145° and 165°, in particular between 150° and 160°, more particular between 155° and 160°, most particular 156°, the rolling off angle of water drop is 1.6°, and/or

XII. wood material comprising a coating, wherein the coating is resistant to mechanical damage and retains at least one of the properties I. to X after a blade scratch test or a tape-and-peel test.

15. A wood material particularly comprising the features of claim 14 obtainable by a process according to the method of any one of claims 1 to 8, 9 to 11 and/or 12 to 13.

Fig. 1

Fig. 2

Fig. 3

EP 3 138 675 A1

Fig. 4

Fig. 5

# a

## curves

Friction Coefficient · Normal force · Penetration depth · Profile

# b

Fig. 6

Fig. 7

Fig. 8

Fig. 9

Fig. 10

Fig. 11

Europäisches
Patentamt

European
Patent Office

Office européen
des brevets

# EUROPEAN SEARCH REPORT

Application Number

EP 15 18 3867

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 945 834 A (CLARKE MICHAEL R ET AL) 23 March 1976 (1976-03-23) * column 3, lines 15-36; example 2 * * column 4, lines 24-25 * * column 5, lines 30-50 * ----- | 1-8,14, 15 | INV. B27K3/00 B05D3/10 B05D7/06 B27K3/20 B27K3/22 B27K3/32 B32B15/10 B82Y30/00 C01G9/02 C09D5/32 C09D7/12 C30B29/16 ADD. B27K3/34 B27K3/52 |

TECHNICAL FIELDS
SEARCHED (IPC)

B27K
B05D
B32B
B82Y
C01G
C09D
C30B

~~The present search report has been drawn up for all claims~~

| Place of search | Date of completion of the search | Examiner |
|---|---|---|
| Munich | 10 February 2016 | Bjola, Bogdan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

Europäisches
Patentamt

European
Patent Office

Office européen
des brevets

Application Number

EP 15 18 3867

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

2, 6-8(completely); 1, 3-5, 14, 15(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

```
1. claims: 2, 6-8(completely); 1, 3-5, 14, 15(partially)

      method for treating wood by applying subsequently two
      compositions each of them comprising ZnO, whereby different
      compounds are employed in these compositions
                              ---

2. claims: 1, 3-5, 14, 15(all partially)

      method for treating wood by applying a compositions
      comprising titanium(IV) isopropoxide
                              ---

3. claims: 9-11(completely); 1, 14, 15(partially)

      method for treating wood by applying subsequently two
      compositions each of them comprising ZnO, whereby a further
      stabilization step is performed
                              ---

4. claims: 12, 13(completely); 1, 14, 15(partially)

      method for treating wood by applying one or more UV
      protecting compositions, whereby a further hydrophobization
      step is performed.
                              ---
```

**EP 3 138 675 A1**

## ANNEX TO THE EUROPEAN SEARCH REPORT
## ON EUROPEAN PATENT APPLICATION NO.

EP 15 18 3867

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2016

| Patent document cited in search report | | Publication date | Patent family member(s) | | Publication date |
|---|---|---|---|---|---|
| US 3945834 | A | 23-03-1976 | CA 1005757 A | | 22-02-1977 |
| | | | US 3945834 A | | 23-03-1976 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HON et al.** *Wood Fiber Sci.,* 1995, vol. 27, 360-367

- **DEKA, M. et al.** *Wood Sci. Technol.,* 2008, vol. 42, 5-20